# EUROPEAN PATENT APPLICATION

(11) **EP 4 576 173 A1**
(43) Date of publication of application: **25.06.2025**
(21) Application number: 23219279.9
(22) Date of filing: 21.12.2023
(51) Int. Cl.: H01L 21/308, H01L 21/3213

(54) **A METHOD FOR ETCHING SIDEWALLS OF FEATURES**

(71) Applicant: AlixLabs AB, 22363 Lund (SE)
(72) Inventor: Suyatin, Dmitry, 22472 Lund (SE); Roozeboom, Freddy, 5582 ED Waalre (NL); Jafari Jam, Reza, 22487 Lund (SE); Constant Stefan Kools, Jacques, 13109 Simiane (NL); Sundqvist, Jonas, 01328 Dresden (DE)
(74) Representative: Invent Horizon IP

(57) **Abstract**

A method for etching sidewalls of features on a substrate is disclosed. The method comprises providing a compound masking layer on the features, which comprises a first masking layer and a second masking layer over the first masking layer. The compound masking layer masks at least part of the field regions and leaves the sidewalls unmasked. The method further comprises etching the sidewalls, where the second masking layer prevents etching of the first masking layer, maintaining the height of the features and the first masking layer with respect to the substrate. The first masking layer is then removed, along with any remaining part of the second masking layer.

## Description

### Field

The technology relates to the field of semiconductor fabrication, specifically to methods for etching sidewalls of features on a substrate. This is a crucial process in the manufacturing of integrated circuits, microelectromechanical systems (MEMS), and other micro- and nano-scale devices.

### Background

In the field of semiconductor processing and manufacturing, it is often necessary to etch critical structures on a substrate to create various electronic devices. One common technique used for etching these structures is angled particle beam etching. This process involves directing a beam of particles, such as ions, at an angle to the substrate surface, which results in the removal of material from the exposed areas of the substrate. This technique is particularly useful for creating structures with complex geometries and high aspect ratios.

However, there are several challenges associated with angled particle beam etching. One such challenge is preserving the original height of the critical structures during the etching process. Maintaining the original height is important for the proper functioning and performance of the devices being manufactured. During angled particle beam etching, the structure height may be reduced simultaneously with lateral geometry changes, which may not be desirable, especially for extremely downscaled structures.

To address this issue, a hard mask is often used to protect the critical structures from height reduction during the etching process. The hard mask is typically made of a material that is resistant to the etching process and is selectively removed after the etching is complete. However, the use of a hard mask may not be effective in preventing the formation of artifacts below the mask during the etching process. These artifacts can affect the critical structure height and profile after removing the hard mask and may require additional processing steps to remove them, which can further reduce the height of the critical structures.

Moreover, the hard mask may not provide adequate protection for the critical structures during the etching process, leading to undesirable changes in the structure profile. This can result in device performance degradation or even device failure.

In summary, the prior art techniques for etching critical structures using angled particle beam etching suffer from several drawbacks, including the inability to effectively preserve the original height of the structures, the formation of artifacts below the hard mask, and the potential for undesirable changes in the structure profile. There is a need for improved methods and techniques for etching critical structures that can overcome these challenges and provide better control over the etching process.

### Summary

According to a first aspect of the disclosure, a method for etching sidewalls of features on a substrate is provided. The features are spaced apart and have respective field regions and sidewalls. The method comprises providing a compound masking layer on the features. This compound masking layer comprises a first masking layer and a second masking layer over the first masking layer. At least part of the field regions is masked and the sidewalls are unmasked by the compound masking layer. The method further comprises etching the sidewalls. During this process, the second masking layer prevents etching of the first masking layer so that a height of the features and the first masking layer with respect to the substrate is maintained. The method comprises removing the first masking layer, whereby any remaining part of the second masking layer is removed. This method ensures that the features are left on the substrate with their original intended height, thus preventing height reduction of the features during sidewall etching.

Optionally in some examples, the first masking layer has the same etch properties as the features on the substrate. This means that etching of the sidewalls of the features removes material of sidewalls of the first masking layer at least at the same rate as for the material of the features. This ensures that the first masking layer and features on the substrate can be removed at the same rate upon the sidewall etching.

Optionally in some examples, the second masking layer is formed of a material with a lower etch rate than the material of the first masking layer. This prevents etching of the first masking layer during the sidewall etching, maintaining the height of the features and the first masking layer with respect to the substrate.

Optionally in some examples, the first masking layer is selectively removed after etching of the sidewalls. This ensures that a height of the features after the sidewall etching is the same as before the sidewall etching. It also removes any remaining part of the second masking layer and any residual material, leaving the features on the substrate with their original intended height.

Optionally in some examples, the first masking layer separates the features from residual material after the etching of the sidewalls. This separation allows the features to have an essentially uninterrupted vertical sidewall with respect to the substrate after sidewall etching, and thus providing for a subsequent facilitated removal of the residual material.

Optionally in some examples, the residual material is attached to the first and/or second masking layer and is thereby removed with the removal of the first masking layer. This ensures that the features are left on the substrate with their original intended height, and the residual material is instead attached to the first masking layer and/or second masking layer to facilitate its removal without affecting the features.

Optionally in some examples, the compound masking layer comprises a third masking layer. The third masking layer is arranged between the features and first masking layer. The material of the third masking layer is different from the material of the features. This is advantageous when it is difficult to find an appropriate material for the first masking layer. The third masking layer separates the features from residual material after sidewall etching, providing for the features to have an essentially uninterrupted vertical sidewall with respect to the substrate after sidewall etching. Selective removal of the third masking layer results in removal of the entire compound masking layer after sidewall etching, leaving the features with the originally intended height on the substrate.

Optionally in some examples, the thickness of the third masking layer is less than the thickness of the first masking layer. This ensures that the third masking layer is thin enough to be effectively etched at least at the same rate as the sidewalls of the features while separating the features from the first masking layer.

Optionally in some examples, the thickness of the third masking layer is less than 10 nm.

Optionally in some examples, an etch rate of sidewalls of the third masking layer corresponds at least to an etch rate of the sidewalls of the features, upon said etching of the sidewalls of the features. This ensures that the third masking layer and the features on the substrate can be removed at the same rate upon the sidewall etching.

Optionally in some examples, the material of the first masking layer is the same as the material of the features. The first masking layer can be provided as a soft mask with the same material as the features, thereby exhibiting the same etch properties as the features, while it can be readily removed when being separated from the features by a third masking layer.

Optionally in some examples, the method includes removing the third masking layer whereby the first masking layer and any remaining part of the second masking layer is removed. This ensures that the entire compound masking layer is removed after the etching of the sidewalls, leaving the features on the substrate with their original intended height.

Optionally in some examples, the third masking layer separates the features from residual material after the etching of the sidewalls so that the features have an essentially uninterrupted vertical sidewall with respect to the substrate. This ensures that the features are left on the substrate with their original intended height, and the residual material is instead attached to any of the masking layers.

Optionally in some examples, the third masking layer separates the first masking layer from the features so that the features and the third masking layer have an essentially uninterrupted vertical sidewall with respect to the substrate after the sidewall etching.

This ensures that the features are left on the substrate with their original intended height, and the residual material is instead attached to the first and/or second masking layer.

### Brief Description of the Drawings

Examples are described in more detail below with reference to the appended drawings.

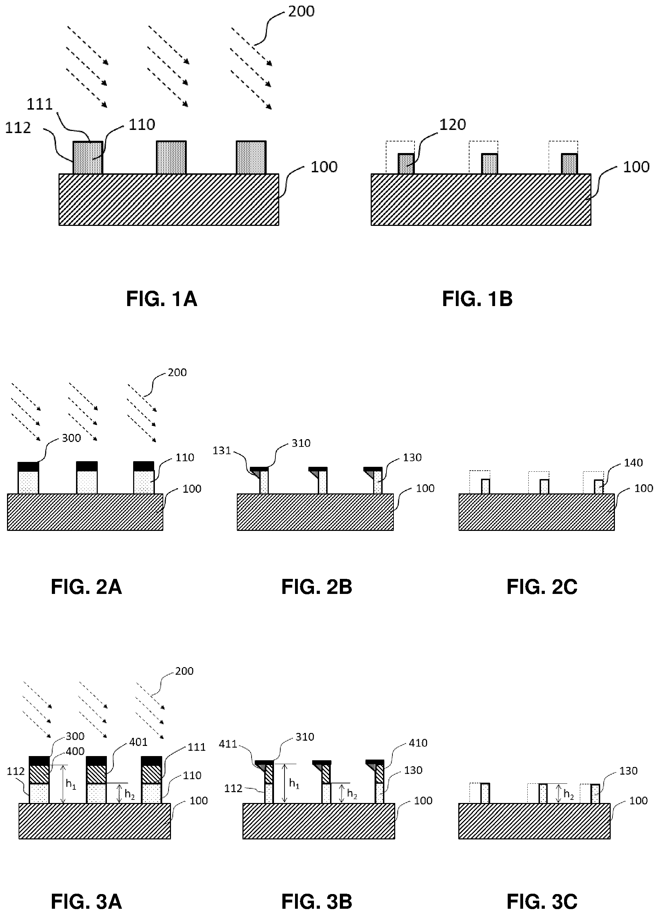

Figures 1A-B are cross-sectional views of a substrate at various intermediate stages of angled particle beam etching without any masking layer, where both the width and the height of the features are reduced.
Figures 2A-C are cross-sectional views of a substrate at various intermediate stages of angled particle beam etching with a hard mask layer 300 and after the masking layer and the unwanted structure 131 removal, showing the formation of artifact features during the etching process.
Figures 3A-C are cross-sectional views of a substrate at various intermediate stages of angled particle beam etching with a compound masking layer comprising the first masking layer 400 and the second masking layer 300, where the original vertical size of the features is maintained after the removal of the compund masking layer.

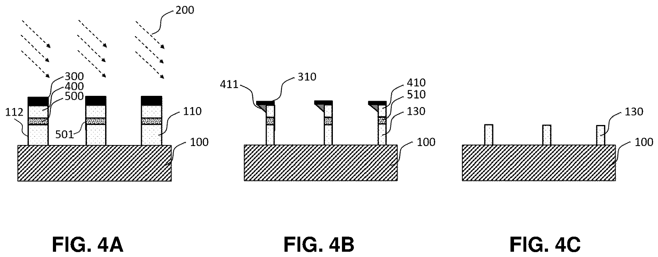

Figures 4A-C are cross-sectional views of a substrate at various intermediate stages of angled particle beam etching with a compound masking layer comprising a third masking layer 500, the first masking layer 400, and the second masking layer 300, illustrating the preservation of the original vertical size of the features after the removal of the masking layers.

### Detailed Description

The detailed description set forth below provides information and examples of the disclosed technology with sufficient detail to enable those skilled in the art to practice the disclosure.

Figures 1A-B show cross-sectional views of a substrate at various intermediate stages of angled particle beam etching without any masking layer. Figure 1A illustrates a substrate 100 with features 110 having field regions 111 and sidewalls 112. The features 110 are also referred to as structures 110 in the present disclosure. Figure 1A shows the initial features 110 at the very beginning of the processing, and Figure 1B shows the same features at the end of the processing, where the original features 110 are transformed into features 120 with reduced lateral dimensions and height. Figure 1B thus shows the substrate 100 after angled particle beam etching, where both the width and the height of the features 110 are reduced. The main goal of the processing performed on the features 110 is to change their lateral dimensions, and the height changes are unwanted.

Figures 2A-C present cross-sectional views of a substrate at various intermediate stages of angled particle beam etching with a hard mask layer 300 and the following removal of the masking layer and the unwanted structures 131 which is residual material. Figures 2A-C demonstrate one known in-the-field solution for avoiding unwanted height reduction using a mask layer. Figure 2A shows the substrate 100 with features 110 and a hard mask layer 300 at the beginning of the process. Figure 2B shows that the original features 110 are transformed into features 130 after the angled particle beam etching and that the original mask 300 is transformed into masking layer 310.

Usually, the masking layer is being etched less, or at least differently, than the material of features 110, this is why artifact structures 131 of residual material are formed in the case of using standard masking layers. These artifact structures 131 are shown in Figure 2B right after the remaining masking layer 310 and are caused by the masking effect of the overhanging masking layer 310. Usually, the masking layer is selectively removed after the processing. However, artifact structures 131 may stay there after the masking layer removal and need to be removed separately. For instance, the artifact structures 131 can be removed with an additional etch process, which will then transform the critical structures 130 into structures 140 with a reduced height, which is unwanted, as shown in Figure 2C. Alternatively, artifact structures 131 may stay after the masking layer 310 removal, and in this case, they are likely to distort or even fail the final devices that are being manufactured with the help of the processing. Figure 2C thus shows the substrate 100 after the removal of the hard mask layer 300 and the unwanted structure 131, leaving features 130 with reduced height compared to the original height of the features 110.

Figures 3A-C are a schematic illustration of a method according to the present disclosure for etching sidewalls 112 of features 110 on a substrate 100. Cross-sectional views of the substrate 100 at various intermediate stages of angled particle beam etching are shown with a compound masking layer comprising a first masking layer 400 and a second masking layer 300 over the first masking layer 400. The method comprises providing the compound masking layer on the features 110, whereby at least part of the field regions 111 is masked and the sidewalls 112 are unmasked by the compound masking layer. Figure 3A shows the substrate 100 with features 110, the first masking layer 400, and the second masking layer 300.

The method comprises etching the sidewalls 112, whereby the second masking layer 300 prevents etching of the first masking layer 400. Figure 3B illustrates the substrate 100 after angled particle beam etching 200, where the second masking layer (denoted 310 after the etching) prevents etching of the first masking layer, thereby maintaining the height (h₁) of the features and the first masking layer (denoted 130 and 410, respectively, after the etching), with respect to the substrate 100.

The method comprises removing the first masking layer 410, whereby any remaining part of the second masking layer 310 is removed. Figure 3C shows the substrate 100 after the removal of the compound masking layer, leaving features (denoted 130 after the compound masking layer removal) with their original intended height (h₂), which corresponds to the height of the features 110 in Figure 3A. The compound masking layer thus prevents height reduction of the features 110 during sidewall etching such as during ion beam etching at a tilted angle.

Any residual material 411 after the sidewall etching is separated from the features 130 by the first masking layer 410. The residual material 411 is instead attached to the first masking layer 410 and/or the second masking layer 310, see Figure 3B. As further seen in Figure 3B the first masking layer 410 may separate the features 130 from the residual material 411 so that the features 130 have an essentially uninterrupted vertical sidewall with respect to the substrate 100. The removal of the first masking layer 410 will also remove any remaining part of the second masking layer 310 as well as the residual material 411. The features 130 will thus be left on the substrate 100 with their original intended height (h₂), while the lateral dimension has been reduced by the sidewall etching, see Figure 3C.

In some examples it is conceivable that the second masking layer 300 prevents etching of the first masking layer 400 but that the first masking layer 400 may still be etched a relatively small amount with respect to its original thickness. A height (h₁) of the features 110, 130 and the first masking layer 400, 410, with respect to the substrate 100 is in such case essentially maintained and in some examples only affected a few percent after the sidewall etching. The first masking layer 410 will in such case still separate any residual material 411 from the features 130, and allow the subsequent removal of the compound masking layer and the residual material 411 so that the original height (h₂) of the features 110, 130, is maintained after the sidewall etching. The second masking layer 300 preventing etching of the first masking layer 400 should thus be construed as essentially preventing the etching of the first masking layer 400 or as reducing or substantially reducing the etching of the first masking layer 400, while providing the advantageous benefits as described where the features 110, 130, maintain their original height (h₂) after the sidewall etching. In some examples the etching of the first masking layer 400 is reduced by at least a factor of two by the second masking layer 300.

In one example the second masking layer 300 is made of Chromium, or SiO₂, or Al₂O₃, and the first masking layer 400 is made of amorphous Si, and the features 110 are made of crystalline Si. The masking layers 300, 400, the substrate 100, and the features 110 may be made of semiconductors, dielectrics, metals, and two-dimensional (2D) materials like graphene or transition-metal dichalcogenide monolayers.

Figures 4A-C are a schematic illustration of a further example of the method according to the present disclosure for etching sidewalls 112 of features 110 on a substrate 100. The compound masking layer may comprise a third masking layer 500. Cross-sectional views of the substrate 100 at various intermediate stages of angled particle beam etching 200 are shown with a compound masking layer comprising a third masking layer 500, the first masking layer 400, and the second masking layer 300. The third masking layer 500 is in arranged between the features 110 and the first masking layer 400, see Figure 4A. The material of the first masking layer 400 is typically the same as the material of the features 110, but in cases where it is difficult to find an appropriate material for the first masking layer 400 it is advantageous to have a third masking layer 500.

The material of the third masking layer 500 is different from the material of the features 110 in this example. The thickness of the third masking layer may be thinner than the first masking layer, and in some examples less than 10 nm. Figure 4B illustrates the substrate 100 after angled particle beam etching, where the third masking layer 500 separates the features 130 from residual material 411 after the sidewall etching. The features 130 may accordingly have an essentially uninterrupted vertical sidewall with respect to the substrate 100. The etch rate of sidewalls 501 of the third masking layer 500 corresponds at least to the etch rate of the sidewalls 112 of the features 110. Selective removal of the third masking layer, denoted 510 in Figure 4B, results in removal of the entire compound masking layer after the sidewall etching, which leaves the features 130 with the originally intended height, see Figure 4C.

The third masking layer 500 is so thin that its etch properties significantly differ when processing the exposed material on the sides, which makes it, due to the small thickness of the matrial, effectively as soft, or even softer than the material of the sidewalls of the critical structure 130 and this material is selected in such way that the whole masking layer can be easily removed later without attacking the critical structure as it is remaining after the processing.

In one example the second masking layer 300 is made of Chromium, or SiO₂, or Al₂O₃, and the first masking layer 400 is made of amorphous Si, or crystalline Si, or polycrystalline Si, and the third masking layer 500 is made of SiO₂, and the features 110 are made of the same material as the first masking layer 400.

In another example the second masking layer 300 is made of Chromium, or SiO₂, or Al₂O₃, and the first masking layer 400 is made of amorphous Si, or crystalline Si, or polycrystalline Si, and the third masking layer 500 is made of graphene, and the features 110 are made of the same material as the first masking layer 400.

The masking layers 300, 400, 500, the substrate 100, and the features 110 may be made of semiconductors, dielectrics, metals, and two-dimensional (2D) materials like graphene or transition-metal dichalcogenide monolayers. It may be especially advantageous to have the third masking layer 500 made of 2D materials.

Further examples of the method for etching sidewalls of features are described in the following.

The method for etching sidewalls of features on a substrate involves a series of steps that are designed to maintain the height of the features while reducing their lateral dimensions. This is achieved through the use of a compound masking layer that is applied to the features on the substrate. The compound masking layer protects the features during the etching process, preventing unwanted height reduction. The operational process involves providing the compound masking layer on the features, etching the sidewalls of the features, and then removing the first masking layer.

### 1. Compound masking layer, sidewall etching and compound masking layer removal

In one example of the disclosure, the etching method involves the use of two masking layers as a compound masking layer, as described above in relation to Figures 3A-C. The compound masking layer is provided on the features on the substrate. This compound masking layer comprises a first masking layer and a second masking layer. The compound masking layer is designed to mask at least part of the field regions of the features, leaving the sidewalls unmasked.

In one configuration, the first masking layer is provided on the features on the substrate. This layer is configured to have the same etch properties as the features on the substrate. This means that the first masking layer and the features on the substrate can be removed at the same rate during the sidewall etching process. The material of the first masking layer is the same as the material of the features in one example. The first masking layer can also be selectively removed after the sidewall etching process.

In some examples, the first masking layer separates the features on the substrate from any residual material that may be left after the sidewall etching process. This residual material is instead attached to the first masking layer and/or the second masking layer. This separation allows the features to have an essentially uninterrupted vertical sidewall with respect to the substrate after the sidewall etching process.

The second masking layer is provided over the first masking layer. This second masking layer is designed to prevent the etching of the first masking layer during the sidewall etching process. The etch rate of the second masking layer may be lower than that of the first masking layer, which helps to protect the first masking layer during the etching process. The second masking layer can also be selectively removed after the sidewall etching process.

In some configurations, the etching method involves the use of three masking layers, as described above in relation to Figures 4A-C. A third masking layer may be provided between the features and the first masking layer. The third masking layer may thus be applied directly to the features on the substrate. The first masking layer is applied over the third masking layer, and the second masking layer is applied over the first masking layer.

This third masking layer is typically thinner than the first masking layer and is made of a different material from the features. The etch rate of the third masking layer corresponds at least to the etch rate of the sidewalls of the features. The third masking layer separates the features from any residual material that may be left after the sidewall etching process. This allows the features to have an essentially uninterrupted vertical sidewall with respect to the substrate after the sidewall etching process. The third masking layer can also be selectively removed after the sidewall etching process, resulting in the removal of the entire compound masking layer as well as in the removal of any residual material.

In some configurations, the method for etching sidewalls of features on a substrate involves a series of steps that are designed to maintain the height of the features while reducing their lateral dimensions. This is achieved through the use of a compound masking layer that is applied to the features on the substrate. The compound masking layer is designed to protect the features during the etching process, preventing unwanted height reduction. The method involves providing the compound masking layer on the features, etching the sidewalls of the features, and then removing the first masking layer.

In one configuration, the process of sidewall etching involves directing an etching agent at the sidewalls of the features. The compound masking layer protects the features during this process, preventing unwanted height reduction. After the sidewall etching process, the first masking layer is removed. This also removes any remaining part of the second masking layer and any residual material that may be left after the sidewall etching process. The features are thus left on the substrate with their original intended height.

### 2. Potential Applications

The method for etching sidewalls of features on a substrate has potential applications in various fields, including semiconductor manufacturing and microfabrication.

### 2.1. Applications in Semiconductor Manufacturing

In some examples, the method can be used in the manufacturing of semiconductors. The method allows for the etching of the sidewalls of features on a substrate without affecting the height of the features. This is particularly useful in the manufacturing of semiconductors, where it is often necessary to reduce the lateral dimensions of features without reducing their height. In one use case, the method can be used in the manufacturing of semiconductor devices such as transistors. The method allows for the etching of the sidewalls of the transistor gate without affecting the height of the gate. This can help to improve the performance of the transistor by reducing the gate length without reducing the gate height.

### 2.2. Applications in Microfabrication

In some examples, the method can be used in microfabrication processes. The method allows for the etching of the sidewalls of features on a substrate without affecting the height of the features. This can be particularly useful in microfabrication processes, where it is often necessary to create features with precise dimensions. In one use case, the method can be used in the fabrication of microelectromechanical systems (MEMS). The method allows for the etching of the sidewalls of features on a substrate without affecting the height of the features. This can be particularly useful in the fabrication of MEMS devices, where it is often necessary to create features with precise dimensions. For example, the method can be used in the fabrication of MEMS accelerometers, where the sidewalls of the accelerometer's sensing elements need to be etched without affecting their height.

In another use case, the method can be used in the fabrication of microfluidic devices. The method allows for the etching of the sidewalls of channels in a microfluidic device without affecting the height of the channels. This can be particularly useful in the fabrication of microfluidic devices, where it is often necessary to create channels with precise dimensions. For example, the method can be used in the fabrication of microfluidic devices for lab-on-a-chip applications, where the sidewalls of the microfluidic channels need to be etched without affecting their height.

In yet another use case, the method can be used in the fabrication of optical devices. The method allows for the etching of the sidewalls of optical waveguides without affecting the height of the waveguides. This can be particularly useful in the fabrication of optical devices, where it is often necessary to create waveguides with precise dimensions. For example, the method can be used in the fabrication of integrated optical devices, where the sidewalls of the optical waveguides need to be etched without affecting their height.

In summary, the method for etching sidewalls of features on a substrate has potential applications in various fields, including semiconductor manufacturing and microfabrication. The method allows for the etching of the sidewalls of features on a substrate without affecting the height of the features. This can be particularly useful in applications where it is necessary to create features with precise dimensions. The method comprises providing a compound masking layer on the features, etching the sidewalls of the features, and then removing the first masking layer. The compound masking layer comprises a first masking layer and a second masking layer, and optionally a third masking layer. The first masking layer is applied directly to the features, while the second masking layer is applied over the first masking layer. The third masking layer, if used, is provided between the features and the first masking layer. After the sidewall etching process, the first masking layer is removed. This also removes any remaining part of the second masking layer and any residual material that may be left after the sidewall etching process. The features are thus left on the substrate with their original intended height.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A method for etching sidewalls of features (110) on a substrate (100), the features being spaced apart and having respective field regions (111) and sidewalls (112), the method comprising
providing a compound masking layer on the features comprising a first masking layer (400) and a second masking layer (300) over the first masking layer, whereby at least part of the field regions is masked and the sidewalls are unmasked by the compound masking layer, the method further comprising
etching the sidewalls, whereby the second masking layer prevents etching of the first masking layer so that a height (h₁) of the features and the first masking layer with respect to the substrate is maintained, and
removing the first masking layer, whereby any remaining part of the second masking layer is removed.

2. Method according to claim 1, wherein the first masking layer has the same etch properties as the features on the substrate, whereby etching of the sidewalls (112) of the features removes material of sidewalls (401) of the first masking layer at least at the same rate as for the material of the features.

3. Method according to claim 1 or 2, wherein the second masking layer is formed of a material with a lower etch rate than the material of the first masking layer.

4. Method according to any of claims 1 - 3, wherein the first masking layer is selectively removed after etching of the sidewalls, whereby a height (h₂) of the features after the sidewall etching is the same as before the sidewall etching.

5. Method according to any of claims 1 - 4, wherein the first masking layer separates the features from residual material (411) after the etching of the sidewalls.

6. Method according to claim 5, wherein the residual material is attached to the first and/or second masking layer and is thereby removed with the removal of the first masking layer.

7. Method according to claim 5 or 6, wherein the first masking layer separates the features from the residual material so that the features have an essentially uninterrupted vertical sidewall with respect to the substrate.

8. Method according to any of claims 1 - 7, wherein the compound masking layer comprises a third masking layer (500), whereby the third masking layer is arranged between the features and the first masking layer, and wherein the material of the third masking layer is different from the material of the features.

9. Method according to claim 8, wherein the thickness of the third masking layer is less than the thickness of the first masking layer.

10. Method according to claim 8 or 9, wherein the thickness of the third masking layer is less than 10 nm.

11. Method according to any of claims 8 - 10, wherein an etch rate of sidewalls (501) of the third masking layer corresponds at least to an etch rate of the sidewalls (112) of the features (110), upon said etching of the sidewalls of the features (110).

12. Method according to any of claims 8 - 11, wherein the material of the first masking layer is the same as the material of the features.

13. Method according to any of claims 8 - 12, wherein the method comprises removing the third masking layer whereby the first masking layer and any remaining part of the second masking layer is removed.

14. Method according to any of claims 8 - 13, wherein the third masking layer separates the features from residual material after the etching of the sidewalls so that the features have an essentially uninterrupted vertical sidewall with respect to the substrate.

15. Method according to claim 14, wherein the third masking layer separates the first masking layer from the features so that the features and the third masking layer have an essentially uninterrupted vertical sidewall with respect to the substrate after the sidewall etching.
